Europäisches Patentamt

European Patent Office

Office européen des brevets

(11) Publication number: **0 129 702**
**B1**

(12) **EUROPEAN PATENT SPECIFICATION**

(45) Date of publication of patent specification: **05.08.87**

(21) Application number: **84105687.2**

(22) Date of filing: **18.05.84**

(51) Int. Cl.⁴: **H 01 L 29/10,** H 01 L 29/743,
H 01 L 29/06

(54) **Voltage breakover protected thyristor having field-containing layer in avalanche voltage breakover zone.**

(30) Priority: **26.05.83 US 498345**

(43) Date of publication of application:
**02.01.85 Bulletin 85/01**

(45) Publication of the grant of the patent:
**05.08.87 Bulletin 87/32**

(84) Designated Contracting States:
**DE FR GB**

(56) References cited:
**DE-A-2 238 564**
**DE-A-3 225 991**
**US-A-4 079 403**
**US-A-4 087 834**
**US-A-4 153 904**
**US-A-4 165 517**
**US-A-4 314 266**

(73) Proprietor: **GENERAL ELECTRIC COMPANY**
**1 River Road**
**Schenectady New York 12305 (US)**

(72) Inventor: **Temple, Victor Albert Keith**
**Main Street**
**Jonesville New York, 12065 (US)**

(74) Representative: **Schüler, Horst, Dr. European**
**Patent Attorney et al**
**Kaiserstrasse 41**
**D-6000 Frankfurt/Main 1 (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**0 129 702**

**Description**

The present invention relates to self-protected thyristors of the type having a localized region within the semiconductor body at which voltage breakover initiates when the forward anode-to-cathode voltage exceeds the forward breakover voltage. The principles of the present invention may be employed to improve the self-protecting semiconductor devices disclosed in Temple U.S. Pat. No. 4,079,403 or to improve the self-protecting semiconductor device disclosed in Temple U.S. Pat. No. 4,087,834, the entire disclosures of which are hereby expressly incorporated by reference.

A thyristor is a solid state device having alternate layers of P conductivity type and N conductivity type semiconductor material. One specific type of thyristor is a silicon-controlled rectifier (SCR) which typically comprises a disc-like semiconductor body having four alternate layers of P and N conductivity type semiconductor material arranged in a PNPN configuration. In an SCR, these layers are termed, in order, the anode, the N-base, the P-base, and the cathode. Usual SCRs have two main terminal electrodes connected to the anode and cathode layers, respectively, and a gate terminal electrode connected to the P-base layer.

As a result of the PNPN configuration, the device includes at least three PN junctions. During forward blocking conditions, an intermediate PN junction is reverse-biased, and may be termed the forward blocking junction. Accordingly, the width of the depletion region layer of the intermediate (or forward blocking) PN junction is relatively wide.

Normally, a thyristor is triggered into conduction by a suitable gating mechanism, such as the supplying of gate current through a gate electrode. Through a regenerative switching action, the thyristor begins conducting, and all three PN junctions become forward biased. Initially, only a small area of the cathode region near the gate electrode contact begins to conduct. This highly-conducting region then supplies the necessary forward current to turn on adjacent regions until the conduction process spreads over the entire cross-section of the cathode. During initial moments of the turn-on process, the entire device current flows through only part of the device, leading to the possibility of localized overheating. This factor is known in the art as the dI/dt limitation.

Accordingly, thyristor devices are carefully designed such that device turn-on occurs in a well-controlled manner, with the largest-possible initial turn-on area. One typical design approach is to employ one of various possible interdigitated arrangements which ensure that no part of the cathode is greater than a certain maximum allowed distance from the gate electrode. Another typical design approach, which results in what is known as an amplifying gate thyristor, is to include a pilot thyristor region. The pilot thyristor region has small lateral dimensions and thus turns on rapidly, and then supplies a strong driving current to the main thyristor regions of the device.

However, as is well known, a thyristor may also be switched into conduction when the forward breakover voltage $V_{BF}$ is exceeded. As the forward breakover voltage $V_{BF}$ is approached, the electric field potential in the depletion region of the reverse-biased intermediate PN junction of the device increases to a point sufficient to produce substantial avalanche multiplication of carriers (electrons and holes) as they travel across the depletion region. The effect can be expressed numerically in terms of an avalanche multiplication factor M, as is known in the art. The additional electron and hole current thus produced causes the device to regeneratively switch to its forward conducting state when the forward breakover voltage $V_{BF}$ is reached. While various design techniques may be employed for increasing the forward breakover voltage $V_{BF}$ of a given device, for example bevelled edge structures, there is always some voltage beyond which the device will break over.

In some thyristor structures, where no particular measures have been taken, it is difficult to predict where forward breakover will occur, and it is accordingly difficult to protect the device from the uncontrolled turn-on process initiated thereby. For the same reasons as summarized above in the context of the dI/dt limitation and normal controlled turn-on of a thyristor, switching a thyristor into conduction by exceeding the forward breakover voltage $V_{BF}$ can result in damage to the device. Thus, one particular cause of damage is the small size of the voltage breakover region which is initially turned on. If the current rises rapidly to large values before a sufficient portion of the main current-carrying part of the device turns on, significant power dissipation occurs, resulting in localized overheating which destroys the device.

Accordingly, various techniques have been developed for localizing the initial forward voltage breakover region within a thyristor. Particularly pertinent in the context of the present invention are the technique disclosed in the above-incorporated Temple U.S. Pat. No. 4,087,834 and the technique disclosed in the above-incorporated Temple U.S. Pat. No. 4,079,403.

Considering first the self-protecting semiconductor device of U.S. Pat. No. 4,087,834, this device includes an etched-down region in the gate region of the device, which etched-down region may also be viewed as a recess. The etched-down region or recess extends partly through the P-base layer and into the depletion region of the intermediate PN junction between the P-base and the N-base. This has the effect of locally increasing the avalanche multiplication factor M to provide a localized avalanche voltage breakover zone. This avalanche voltage breakover zone is located at a portion of the device where initial conduction occurring in the avalanche voltage breakover zone results in non-destructive controlled turn-on of the entire device. Preferably, this location is in the center of the normal thyristor gating structure, which preferably is an amplified gate structure of the type comprising a pilot thyristor.

Considering now the disclosure of the other of the above-incorporated U.S. patents, Temple No.

2

4,079,403, a junction curvature technique is employed for providing a lower breakdown voltage in or near the gate area of the device. Specifically, the junction between the P-base and the N-base curves upward to the extent that this junction terminates at the upper semiconductor surface of the device. A portion of the N-base actually extends to the device upper surface in the center of the device, with an annular P-base diffusion then surrounding the upwardly extending portion of the N-base. Thus, the device can be fabricated employing the well-known planar process, with no need for a controlled etch to form a recess.

By way of further example, other self-protected thyristor structures for localizing the initial forward breakover region within a thyristor are disclosed in Temple et al U.S. Pat. No. 4,165,517 and in Temple U.S. Pat. No. 4,314,266. As disclosed in these patents, the initial avalanche voltage breakover region can be localized by locally increasing the lifetime of minority charge carriers or by locally producing a region of lower resistivity. Still further, as disclosed in DE—A—No. 2,238,564 by Karl Peter Frohmader, pre-etch techniques may be employed to provide a locally thinner base.

Of the various techniques for localizing a forward voltage breakover region, the technique of providing an etched-down region or recess partly through the P-base layer as disclosed in the above-incorporated Temple U.S. Pat. No. 4,087,834 and the technique of employing a curved junction as disclosed in the above-incorporated Temple U.S. Pat. No. 4,079,403 have advantages in fabrication, as well as other advantages. In particular, as disclosed in the '834 patent the single etch step required can be performed at any convenient point in the process after the P-base layer has been formed. As disclosed in the '403 patent, the device can readily be formed employing conventional planar processing steps, including masking and gas source diffusion.

However, a disadvantage of the resultant structure in either case is that electric field lines terminate on a semiconductor surface. In the case of the etched-down recess structure, electric field lines terminate on the interior semiconductor surface of this etched-down region or recess. In the case of the curved junction structure, electric field lines terminate on the device upper semiconductor surface to which the portion of the N-base extends. The undesirable result is that, during forward voltage breakover, current thus flows on a semiconductor surface of the device. It is known that surface current is much more likely to cause damage to the device than current flow in bulk semiconductor material. Since electric field lines terminate at a semiconductor surface, a passivating film is required and, with excessive surface current flow, the union between the semiconductor surface and the passivating film is usually the first portion of the device to be damaged.

Another disadvantage, specifically applicable to the recess structure of Pat. No. 4,087,834, is that it is somewhat critical that the etch depth be carefully controlled during fabrication to avoid wide variations in the forward breakover voltage from one particular device to another.

Similarly, another disadvantage specifically applicable to the curved junction structure of Pat. No. 4,079,403 is that better degree of control over the breakdown voltage in the localized breakover one is desirable. In particular, it is desired that this voltage be as high as possible so that the overall device breakdown voltage is not unduly limited, while at the same time ensuring that initial forward breakdown will occur in the desired localized region.

Thus, while the approaches and structures disclosed in the above-incorporated Temple U.S. Pat. Nos. 4,087,834 and 4,079,403 are effective to serve the intended purpose, they nevertheless in each case leave room for improvement.

Summary of the invention

Accordingly, it is an overall object of the invention to provide a thyristor structure which safely turns on when the anode-to-cathode voltage exceeds the forward breakover voltage $V_{BF}$.

It is a more particular object of the invention to employ the general technique of localizing the initial forward voltage breakover region of a thyristor while, at the same time, precluding electric field lines from terminating at the semiconductor surface in the voltage breakover region.

It is another object of the invention to provide a thyristor structure which reduces current flow over a semiconductor surface during device forward breakover.

It is yet another object of the invention to provide a thyristor structure which avoids the need for a surface passivating film.

It is another more particular object of the invention to provide a thyristor structure of the general type wherein an etched-down region or recess is employed, but wherein control of the etch depth during fabrication is not extremely critical.

It is another more particular object of the invention to provide a thyristor structure of the general type wherein a curved junction is employed to localize the initial forward voltage breakover region, and wherein the breakdown voltage characteristic can be readily controlled.

Briefly, and in accordance with an overall concept of the invention, the semiconductor surface on which electric field lines would otherwise terminate in the etched-down recess structure or the curved junction structure as summarized above includes that is herein termed a field-containing layer. Stated in other words, the surface-adjacent region of the recess or the surface-adjacent of the extending portion of the N-base comprises a field-containing layer. The field-containing layer is of P conductivity type, but is doped higher in concentration than the P-base region, and forms an electrical extension of the P-base region. Significantly, the field-containing layer thickness exceeds the depletion-layer width within the

3

field-containing layer under device forward blocking conditions when the intermediate PN junction is reverse-biased.

More particularly, a thyristor semiconductor switching device self-protected against voltage breakover failure in accordance with the invention includes a first main terminal region of one conductivity type, for example, a $P^+$ anode region (highly-doped to P conductivity type), and a first base region layer of opposite conductivity type, for example, an N-base region (doped to a reference concentration with N conductivity type impurities) overlying the $P^+$ anode region layer and defining a first PN junction with the $P^+$ anode region layer. The device also includes a second base region layer of the one conductivity type, for example, a P-base region (doped to a reference concentration with P conductivity type impurities) overlying the first base region layer and defining a second PN junction with the first base region layer. This second PN junction is the forward blocking junction in the overall device. Portions of the second base region boundary extend to the surface of the overall device.

To complete the basic four-layer device structure, a second main terminal region of the opposite conductivity type, for example, an $N^+$ main emitter region (highly-doped to N conductivity type) overlies a portion of the second base region layer and defines a third PN junction with the second base region layer at a portion of the second base region boundary. This third PN junction generally defines the location of a main conduction zone within the device.

In accordance with the invention, a localized avalanche voltage breakover zone is located in a portion of the device separate from the main conduction zone. In one form, the avalanche voltage breakover zone includes a recess extending from the second base region boundary into the device. The surface-adjacent region of the recess comprises a field-containing layer of the one conductivity type, P conductivity type in this example, doped higher in concentration than the second base region layer, and comprising an electrical extension of the second base region layer. The depth of the recess is such that at least a portion of the depletion region on the P-side of the forward blocking PN junction extends into the field-containing layer. The field-containing layer thickness exceeds the depletion layer width in the field-containing layer under device forward blocking conditions when the second PN junction (the junction between the P-base and the N-base) is reverse-biased. The recess extends into the device to a depth sufficient to reduce the breakdown voltage of the second PN junction in the avalanche voltage breakover zone. Due to the field-containing layer, the electric field resulting from the voltage across the intermediate PN junction does not extend to an outer surface of the device in the voltage breakover region.

In one embodiment of the invention, the recess extends from the second base (P-base) region outer boundary only partly through the second base (P-base) region layer. In another embodiment, the recess extends from the second base region (P-base) region outer boundary completely through the second base (P-base) region layer into the first base (N-base) region layer. This embodiment is particularly advantageous from the standpoint of fabrication because it is not critically necessary to achieve a precise etch depth. The structure of the one embodiment where the recess extends only partly through the P-base region layer is more difficult to achieve because the etch depth must be more precisely controlled. However, this precise control is necessary where the forward breakover voltage $V_{BF}$ in the localized avalanche voltage breakover zone would otherwise be unacceptably low.

In another form, the avalanche voltage breakover zone is planar and comprises a portion of the first base region (N-base) layer extending through the second base region (P-base) layer such that a portion of the second PN junction has a radius of curvature and such that a gap is defined by the N-base extending portion between opposed portions of the second base (P-base) layer. The surface-adjacent region of the N-base extending portion comprises a field-containing layer of P conductivity type doped higher in concentration than the second base region and comprising an electrical extension of the second base region layer. The field-containing layer thickness exceeds the depletion layer width in the field-containing layer under device forward blocking conditions when the second PN junction is reverse-biased.

In any of these embodiments, the P conductivity type field-containing layer may be formed through any suitable process. Conveniently, an ion implantation process may be employed, with suitable masking to protect other portions of the device from the ion beam. As an alternative, particularly for a planar device, gas source diffusion may be employed, again with a suitable mask, such as an oxide mask.

In order to facilitate controlled turn-on under forward breakover voltage conditions, the avalanche voltage breakover zone is preferably located within a device gating zone employed for normal operation of the device. The device gating zone may comprise a gate electrode conventionally in electrical contact with the second base (P base) region layer and serving to inject triggering current into the second base (P base) region. The gate electrode is preferably of ring-like configuration, and the recess of the avalanche voltage breakover zone is located within the generally ring-like configuration of the gate electrode. Alternatively, the gating zone may be triggered by light.

Preferably, the thyristor is an amplifying-gate thyristor including, in separate regions or zones of the device, a pilot thyristor and a main thyristor. The amplifying-gate thyristor further includes a pilot emitter of the opposite conductivity type, $N^+$ in this example, immediately encircling the gating zone and defining a fourth PN junction with the second base (P-base) region layer at another portion of the second base (P-base) region boundary. An ohmic contact is provided between the $N^+$ pilot emitter and a portion of the second base (P-base) region layer immediately outside the ring-like configuration of the $N^+$ pilot emitter.

## 0 129 702

Brief description of the drawings

While the novel features of the invention are set forth with particularity in the appended claims, the invention, both as to organization and content, will be better understood and appreciated from the following detailed description taken in conjunction with the drawings in which:

Figure 1 is a perspective view, partly sectioned, of an amplifying-gate thyristor in accordance with a first embodiment of the invention;

Figure 2 is a plot depicting electric field strength as a function of distance along the line X—X of Figure 1 passing through the depletion region in the avalanche voltage breakover zone of the device of Figure 1;

Figure 3 is a plot of electric field strength as a function of distance along the line Y—Y of Figure 1 extending through the depletion region in the portion of the device other than the avalanche voltage breakover zone;

Figure 4 is a perspective view, partly sectioned, of another embodiment of a self-protected thyristor in accordance with the invention;

Figure 5 is a plot of electric field strength as a function of distance along line X—X in Figure 4 extending through the depletion region layer in the avalanche voltage breakover zone of the Figure 4 device; and

Figure 6 is a perspective view, partly sectioned, of a self-protected thyristor of planar configuration in accordance with the invention.

Detailed description of the preferred embodiments

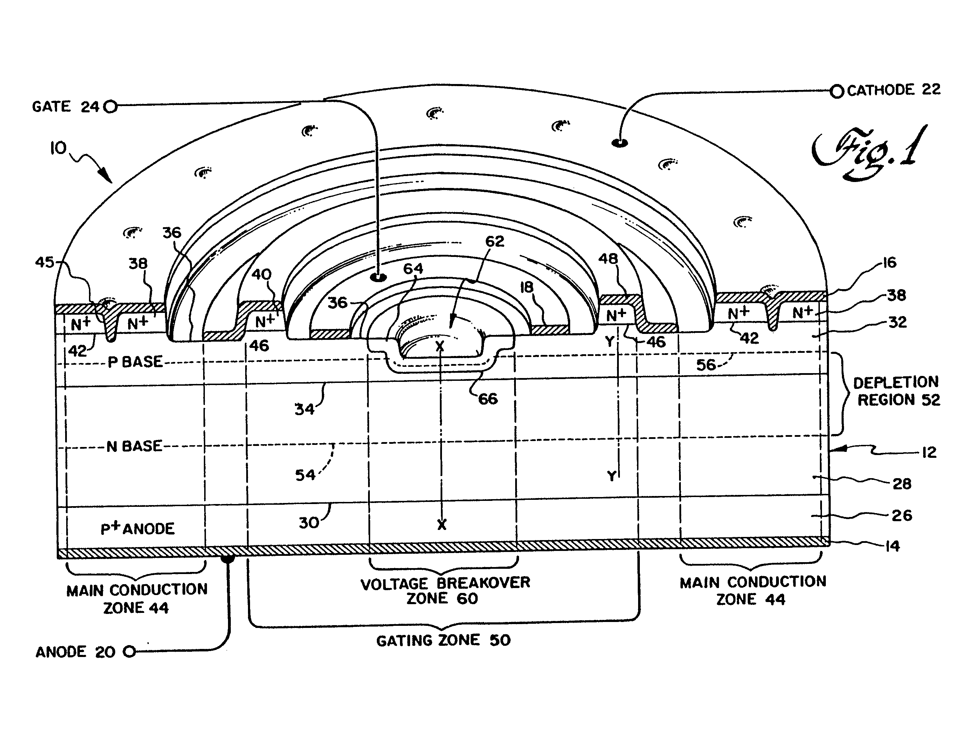

Referring first to Figure 1, a thyristor 10 comprises a four-layer, disc-like silicon semiconductor body 12 having, on generally opposite sides of body 12, an anode electrode metallization layer 14 and a cathode electrode metallization layer 16, as well as gate electrode metallization 18 on the same side as the cathode electrode 16. Respective device anode 20, cathode 22 and gate 24 terminals are electrically connected to the respective metallization layers.

The silicon semiconductor body 12 includes, in series, a $P^+$ anode region 26 (highly doped to P conductivity type), a first or N base region layer 28 (doped to a reference concentration with N conductivity type impurities) overlying the $P^+$ anode region and defining a first PN junction 30 with the $P^+$ anode region, and a second base (P-base) region layer 32 (doped to a reference concentration with P conductivity type impurities) overlying the P-base region layer 28 and defining a second PN junction 34 with the P-base region layer 28. The second base (P-base) region layer 32 has a boundary 36 opposite the second PN junction 34. As may be seen in Figure 1, portions of the boundary 36 comprise surfaces of the semiconductor body 12, while other portions of the boundary 36 are covered by ring-like concentric $N^+$ cathode regions 38 and 40 (highly-doped to N conductivity type), which are also referred to as emitter regions 38 and 40. In particular, the $N^+$ emitter region 38 comprises the cathode main terminal region of the device 10 and overlies a portion of the second base (P-base) region layer 32 to define a third PN junction 42 with the second base (P-base) region layer 32. The third PN junction 42 generally defines the location of a main conduction zone 44 within the device 10.

As is conventional practice, the anode metallization 14 is in ohmic contact with the $P^+$ anode region 26, and the cathode metallization 16 is in ohmic contact with the $N^+$ emitter region 38. Further, in order to improve the dV/dt rating of the device 10, a number of conventional cathode shorts are provided in the form of extensions 45 of the cathode metallization layer 16 through apertures in the $N^+$ emitter layer 38 to contact the P-base layer 32. As is known, excessive dV/dt during device operation produces a capacitive current which can cause a thyristor to switch into its forward conducting state at voltages well below the forward breakover voltage $V_{BF}$. This can occur under transient conditions where anode-to-cathode voltage increases rapidly, but nevertheless remains below the forward breakover voltage $V_{BF}$.

The device 10 additionally includes an amplifying-gate structure generally comprising the gate electrode 18, and the $N^+$ emitter 40, which may be termed a pilot emitter 40 and defines a fourth PN junction 46 with the second base (P-base) region layer 32. A pilot emitter metallized electrode 48 provides an ohmic contact between the $N^+$ pilot emitter 40 and a portion of the second base (P-base) region layer 32 immediately outside the ring-like configuration of the pilot emitter 40. The gate electrode 18 itself is also ring-like, and is in electrical contact with the second base (P-base) region layer 32. The pilot emitter metallization electrode 48 is not connected to any external contact of the device 10.

The particular device 10 shown is of annular configuration, with the ring-like pilot emitter 40 inward of the main emitter 38, which is also of annular configuration. The gate electrode 18 is located inward of the pilot emitter 40. Thus the gate electrode 18 and the $N^+$ pilot emitter 40 generally define a gating zone 50 within the device 10.

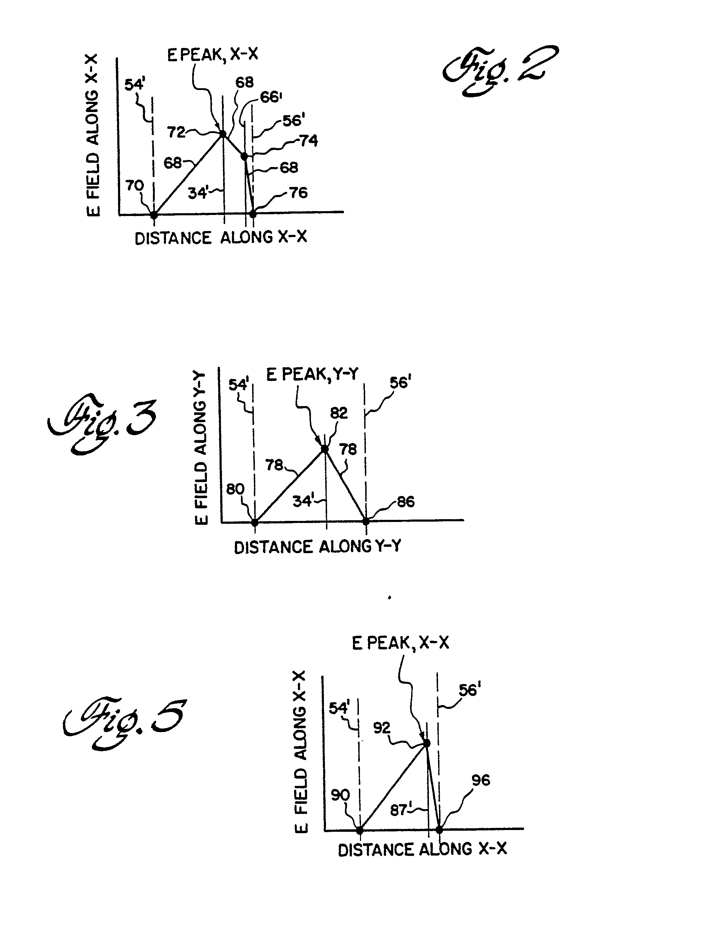

In the general operation of the thyristor device 10 as thus far described, during forward blocking conditions the $P^+$ anode region 26 is biased positively with respect to the $N^+$ main emitter region 38 through appropriate external circuitry (not shown) connected to the anode terminal 20 and the cathode terminal 22. When the device 10 is in the forward blocking state, the first PN junction 30 between the $P^+$ anode 26 and the first base (N-base) region layer 28 and the third PN junction 42 between the second base (P-base) 32 and the $N^+$ main emitter 38 are both forward biased; however, the second or intermediate PN junction 34 between the first base (N-base) region layer 28 and the second base (P-base) region layer 32 is reverse-biased. Accordingly, the second PN junction 34 serves as the device forward blocking junction and, under forward blocking conditions, has a relatively wide depletion layer width, depicted in Figure 1 as a

5

depletion region 52. Substantially all of the forward voltage drop occurs across the depletion region 52 and, accordingly, an electric field is established within the depletion region 52, but generally not outside the depletion region 52. This electric-field is described in greater detail hereinbelow with reference to Figures 2 and 3.

From Figure 1, it will be seen that the depletion region 52 extends on either side of the blocking PN junction 34, and thus the depletion region 52 has a portion in the N-base region 28 extending to a boundary 54, and has a portion in the P-base region 32 extending to a boundary 56.

The actual width of the depletion region 52 between the boundaries 54 and 56 is dependent upon the magnitude of the voltage applied to the device 10, as well as upon the particular impurity concentrations of the various layers of the device 10. It will be appreciated that the first PN junction 30 and the third PN junction 42 also have depletion regions, which are relatively narrow when these junctions are forward-biased. Inasmuch as the present invention is not directly concerned with these particular depletion regions, for clarity of illustration they are omitted from the drawing.

As is known, during normal operation, a thyristor such as the thyristor 10 is gated into conduction by applying gate current to the gate electrode 18 via the terminal 24. The amplifying gate structure which serves as a pilot thyristor turns on rapidly because of its small lateral dimensions. A relatively greater pilot current is then conducted from the $N^+$ pilot emitter 40 via the ohmic contact provided by the pilot emitter metallization 48 to the second base (P-base) region layer 32 to trigger the main conduction zone 44 of the thyristor 10 into conduction.

In accordance with the invention, the device 10 also includes a localized avalanche voltage breakover zone, generally designated 60, in a portion of the device 10 separate from the main conduction zone 44. Preferably, in order to facilitate well-controlled device turn-on under forward voltage breakover conditions, the avalanche voltage breakover zone 60 is located in the center of the gating zone 50 and, more particularly, inwardly of the ring-like configuration of the gate electrode 18. Thus, the benefits of the amplified gate structure, employed in any event to increase the dI/dt capability during normal turn-on, are also realized when conduction is triggered by forward voltage breakover in the localized voltage breakover zone 60.

More particularly, the voltage breakover zone 60 comprises a recess 62, or etched-down region, extending from the second base (P-base) region 32 boundary 36 into the device 10. The surface-adjacent region of the recess 62 comprises a field-containing layer 64 of P conductivity type, but doped higher in concentration than the second base (P-base) region layer 32. This field-containing layer 64 forms an electrical extension of the second base (P-base) region layer 32.

Although the field-containing layer 64 is depicted, for purposes of illustration, as having definite boundaries, such as a boundary 66 between the field-containing layer 64 and the second base (P-base) layer 32, in practice the doping profile of the field-containing layer 64 is tapered, with a maximum impurity concentration right at the interior surface of the recess 62 and gradually decreasing with distance therefrom to smoothly merge with the doping concentration of the second base (P-base) region layer 32.

By way of example and not limitation, the following table indicates suitable dimensions and impurity concentrations for the Figure 1 device 10.

| Region | Thickness (microns) | Impurity concentration (dopant atoms per cm³) |
|---|---|---|
| $P^+$ Anode 26 | 50 | $1 \times 10^{19}$ |
| N-base 28 | 400 | $4 \times 10^{13}$ (approximately) |
| P-base 32 in main conduction zone 44 | 50 | $1 \times 10^{16}$ (average) |
| P-base 32 in voltage breakover zone 60 | 10 | $2 \times 10^{14}$ (average) |
| P field-containing layer 64 | 10 | $5 \times 10^{17}$ |
| $N^+$ emitters 38 and 40 | 10 | $1 \times 10^{20}$ |

A typical, non-protected thyristor device, for example, would ideally have a $V_{BF}$ of 3200 volts in the main portion of the device. Such a device would be derated to 2600 volts to ensure an adequate margin for safety. In the absence of the recess 62, under device forward blocking conditions approximately 600 to 700 volts would be supported by the depletion region 52 portion within the P-base region 32. A partial etch into the P-base region 32 as in Figure 1 reduces this 600 to 700 volts by about 25%, acceptably reducing the device $V_{BF}$ rating by about 250 volts in return for self protection.

The recess 62, including the field-containing layer 64, extends into the device 10 to a depth sufficient to reduce the breakdown voltage of the second PN junction 34 in the avalanche voltage breakover zone 60. In the Figure 1 embodiment, the recess extends only partly through the second base (P-base) region layer 32, and extends into the depletion layer region 52. The recess 62 or, more particularly, the field-containing layer 64 of the recess 62, thus distorts the shape of the depletion region 52 boundary 56. Inasmuch as the field-containing layer 64 is of the same conductivity type as the second base (P-base) region 32 and forms an electrical extension thereof, the upper boundary 56 of the depletion region 52 extends within and is partly contained in the field-containing layer 64. A portion of the depletion-layer width is accordingly in the field-containing layer 64 under device forward blocking conditions when the second PN junction 34 is reverse-biased.

Significantly, the thickness of the field-containing layer 64 exceeds the depletion layer width in the field-containing layer 64 under device 10 forward blocking conditions when the second PN junction 34 is reverse-biased. This can be accomplished, employing known fabrication techniques, by ensuring that the product of the thickness of and impurity concentration in the field-containing layer 64 is greater than

$$\frac{\varepsilon E_{BF}}{q},$$

wherein $\varepsilon$ is the dielectric constant of silicon, $E_{BF}$ is the local peak electric field at breakover, and q is the electron charge.

For a given forward voltage, the peak electric field in the voltage breakover zone 60 is greater in comparison to the peak electric field in other regions of the device 10, such as in the main conduction zone 44. This increases the avalanche multiplication factor M in the voltage breakover zone for a given applied voltage such that a lower forward breakover voltage $V_{BF}$ is achieved in the voltage breakover zone 60. This result will be apparent from a comparison of Figures 2 and 3. In particular, Figure 2 shows the depletion region electric field along the line X—X in the voltage breakover zone 60 of Figure 1, and Figure 3 depicts the electric field through the depletion region along line Y—Y in a region of the device other than at the voltage breakover zone 60 of Figure 1.

As represented in Figure 2, an electric field exists substantially only in the depletion region 52 of Figure 1, and may be considered as essentially zero in all other device portions since nearly all of the forward voltage drop of the device during the forward blocking condition is applied across the depletion region 52 of the second PN junction 34. Thus, in Figure 2 dashed line 54' represents the depletion region 52 boundary 54 in the N-base 28 of Figure 1, solid line 34' represents the PN junction 34 between the N-base 28 and the P-base 32 of Figure 1, the solid line 66' represents the Figure 1 boundary 66 between the P-base 32 and the P conductivity type field terminating layer 64, and the dashed line 56' represents the depletion region 52 boundary 56 within the P field-containing layer 64. The segmented line 68 is then a plot of electric field, E, as a function of distance along the line X—X of Figure 1. At point 70, where the plot 68 crosses representation 54' of the depletion region 52 boundary 54, the electric field is substantially zero. At point 72, where the plot 68 crosses representation 34' of the PN junction 34, the electric field is at its peak. At point 74, where the plot 68 crosses representation 66' of the boundary 66, the electric field is at an intermediate level. Finally, at point 76, where the plot 68 crosses representation 56' of the depletion region 52 boundary 56, the electric field is substantially zero. The electric field is also substantially zero below the point 70 and above the point 76.

Figure 3, which in like manner plots, as segmented line 78, the electric field along line Y—Y in a region of the device 10 away from the voltage breakover zone 60 may be contrasted. In Figure 3, the point 80 is directly comparable to the point 70 in Figure 2, and is on the line 54' which represents the depletion region 52 boundary 54 in the Figure 1 N-base region layer 28. The point 82 may be generally compared to the point 72 in Figure 2, and is on the line 34' which represents the Figure 1 PN junction 34 between the N-base 28 and the P-base 32. The peak electric field at the point 82 is lower in Figure 3, however, than at the Figure 2 point 72, for reasons presently discussed. Finally, the Figure 3 point 86 is comparable to the Figure 2 point 76, and is on the line 56' which represents the Figure 1 depletion region 52 boundary 56 in the P-base region 32. The Figure 2 line 66' is not found in the Figure 3 because the Figure 1 line Y—Y does not pass through the field-containing layer 64 of the voltage breakover zone 60.

Comparing Figures 2 and 3, it will be appreciated that the area under the curve is the same in both Figures 2 and 3, since voltage is proportional to the integral of electric field across the depletion region 52. With a shorter distance between the points 70 and 76 in Figure 2 (corresponding to the distance in Figure 1 between the depletion region 52 boundaries 54 and 56 within the voltage breakover zone 60) compared to the distance between points 80 and 86 in Figure 3 (corresponding to the distance in Figure 1 between the depletion region 52 boundaries 54 and 56 outside the voltage breakover zone 60), the resultant $E_{peak}$, X—X in Figure 2 is higher than the peak electric field $E_{peak}$, Y—Y in Figure 3. Thus, the avalanche breakdown voltage within the voltage breakover zone 60 is lower than that of the normal junction region.

One particular disadvantage of the Figure 1 embodiment, shared also with the device disclosed in the above-incorporated Temple U.S. Pat. No. 4,087,834, is that the etch depth during fabrication of the recess 62 must be carefully and critically controlled during processing. As is known, it is desirable to have as few critical processing steps as possible in semiconductor fabricating processes in order to achieve a high device yield.

Figure 4 depicts the structure of a device 10' which is less critical to manufacture. The Figure 4 device 10′ is similar in many respects to the Figure 1 device 10, and identical reference numerals are employed to designate corresponding elements, the descriptions of which, in general, are not repeated. The Figure 4 structure however includes a recess 62′ extending from the second base (P-base) region 32 boundary 36 completely through the second base region layer 32, and even slightly into the first base (N-base) region layer 28. The recess 62′ includes a P conductivity type field-containing layer 64′ doped higher in concentration than the second base (P-base) region layer 32, and of thickness greater than that of the depletion-layer within the field-containing layer 64′ under device forward blocking conditions when the second PN junction 34 is reverse-biased. Thus, there is a PN junction 87 between the P type field-containing layer 64′ and the N-base layer 28, which PN junction 87 is a continuation of the second PN junction 34. Along portions of the recess 62′ above the N-base 28, there is a boundary 66 between the P-base 32 and the P-type field-containing layer 64′. In Figure 4, as in Figure 1, electric field at the surface of the recess 62′ is zero. Within the voltage breakover zone 60 of the Figure 4 device, the forward blocking PN junction 34 is between the N-base 28 and the field-containing layer 64′. Within the remainder of the Figure 4 device 10′, the forward blocking PN junction 34 is between the N-base 28 and the P-base 32.

Figure 5, which may in general be compared with Figure 2, is a plot of electric field as a function of distance along line X—X in the device 10′ of Figure 4. In Figure 5, point 90 is on the line 54′ which represents the Figure 4 boundary 54 of the depletion region 52 in the first base (N-base) region layer 28. At point 90 the electric field is zero. Point 92 is on a line 87′ which represents the Figure 4 PN junction 87 between the N-base region layer 28 and the P conductivity type field containing layer 64′. The electric field peaks at point 92. Finally, point 96 is on the line 56′ which represents the Figure 4 boundary 56 of the depletion region 52 in the P conductivity type field-containing layer 64′.

The electric field along the line Y—Y in Figure 4 is essentially identical to the electric field along line Y—Y in Figure 1, and thus the plot of Figure 3 applies to Figure 4 as well as to Figure 1.

The peak electric field intensity $E_{peak}$, X—X in Figure 5 exceeds the peak electric field intensity plotted in Figures 2 and 3. The Figure 4 device 10′ has lower avalanche breakdown voltage than the Figure 1 device 10.

By way of example and not limitation, the following table identifies suitable dimensions and impurity concentrations for the Figure 4 device 10′.

| Region | Thickness (microns) | Impurity concentration (dopant atoms per cm³) |
|---|---|---|
| P⁺ Anode 26 | 50 | $1 \times 10^{19}$ |
| N-base 28 | 400 | $4 \times 10^{13}$ (approximately) |
| P-base 32 in main conduction zone 44 | 50 | $1 \times 10^{16}$ (average) |
| P field-containing layer 64′ | 10 | $5 \times 10^{17}$ |
| N⁺ emitters 38 and 40 | 10 | $1 \times 10^{20}$ |

Considering the resultant $V_{BF}$ rating, again assuming a basic device structure which would ideally have a $V_{BF}$ of 3200 volts, the etch completely through the P-base region 32 to provide the Figure 4 recess 62′ substantially eliminates the voltage supported by the depletion region 52 portion within the P-base region 32. Thus, the device $V_{BF}$ rating is reduced by about 600 to 700 volts, in this example.

It may be noted, that while the Figure 4 embodiment is easier to fabricate than the Figure 1 embodiment, the breakdown voltage may be unacceptably low, depending upon the application of the particular device 10′. This is because the depletion region voltage on the P side of the PN junction 34 is substantially zero as a result of the relatively heavily P-doped field-containing layer 64′ extending into the N-base region 28. In short, as between the Figure 1 and Figure 4 embodiments, the difficulty in achieving the specific etch depth of the Figure 1 embodiment must be weighed against the decrease in device forward breakdown voltage of the Figure 4 embodiment.

Fabrication of either the device 10 of Figure 1 or the device 10′ of Figure 4 may be achieved employing conventional processing steps. Typically, processing begins with an N conductivity type silicon chip or wafer into which impurities are diffused through the top and bottom surfaces to respectively form the P-base region 32 and the P⁺ anode region 26 around the N-base region 52. A top N⁺ layer is formed by any suitable method such as diffusion, epitaxial growth, or ion implantation. Alternatively, any one or more of the other zones may be formed by epitaxial growth.

After a four-layer PNPN semiconductor body has been produced, the N⁺ main emitter region 38 and N⁺ pilot emitter region 40 are defined by etching away a portion of the top N⁺ layer through suitable masking and etching processes.

Next, the recess 62 or 62′ is formed by any suitable technique, which may broadly be considered etching. Various processes may be employed including, but not limited to, chemical etching, plasma etching and ion beam etching.

8

The field-containing layer 64 or 64' is next formed on the interior surface of the recess 62 or 62', respectively. One suitable technique is ion implantation. As is known, ion implantation is the introduction of energetic charged atomic particles into a semiconductor substrate for the purpose of changing the properties of the substrate. The entire wafer is then heated to diffuse the introduced impurities to reach their ultimate profile. Ion implantation is advantageous in that it facilitates precise control over total dose, depth profile, and area uniformity. Ion implantation is described in detail in the literature. For example, see J. F. Gibbons, "Ion Implantation in Semiconductors—Part I: Range Distribution Theory and Experiments", *Proceedings of the IEEE*, Vol. 56, No. 3, pages 295—319 (March 1968); and J. F. Gibbons, "Ion Implantation in Semiconductors—Part II: Damage Production and Annealing", *Proceedings of the IEEE*, Vol. 60, No. 9, pages 1062—1096 (Sept. 1972).

Alternatively, the field-containing layer 64 or 64' may be formed employing gas-source diffusion, with suitable masking, such as by providing an oxide layer over other device portions.

At an appropriate point in the process, metallization areas are provided on the top and bottom surfaces of the device. Typically, the entire top and bottom surfaces are first metallized, and then the top surface is selectively etched to define the separate cathode electrode 16, gate electrode 18, and pilot emitter electrode 48.

While the devices depicted in Figures 1 and 4 have been described above as conventionally-gated amplifying-gate thyristors, it will be appreciated that they may be gated by other means as well; in particular, by light. The structures of Figure 1 and 4 are particularly adapted to be triggered by light (not limited to visible light) if a suitable beam of light is directed into the voltage breakover zone 60 via such means as an optical fiber (not shown). Photocurrent is produced in the form of electron-hole pairs generated in the space-charge region of the reverse-biased junction 34, and these electron-hole pairs are substantially instantaneously separated by the electric field existing within the depletion region 52. With sufficient light intensity, the device switches into forward conduction.

Similarly, it will be appreciated that the voltage breakover zone 60 of the invention need not be applied to an amplifying-gate thyristor, but to other forms of thyristor as well.

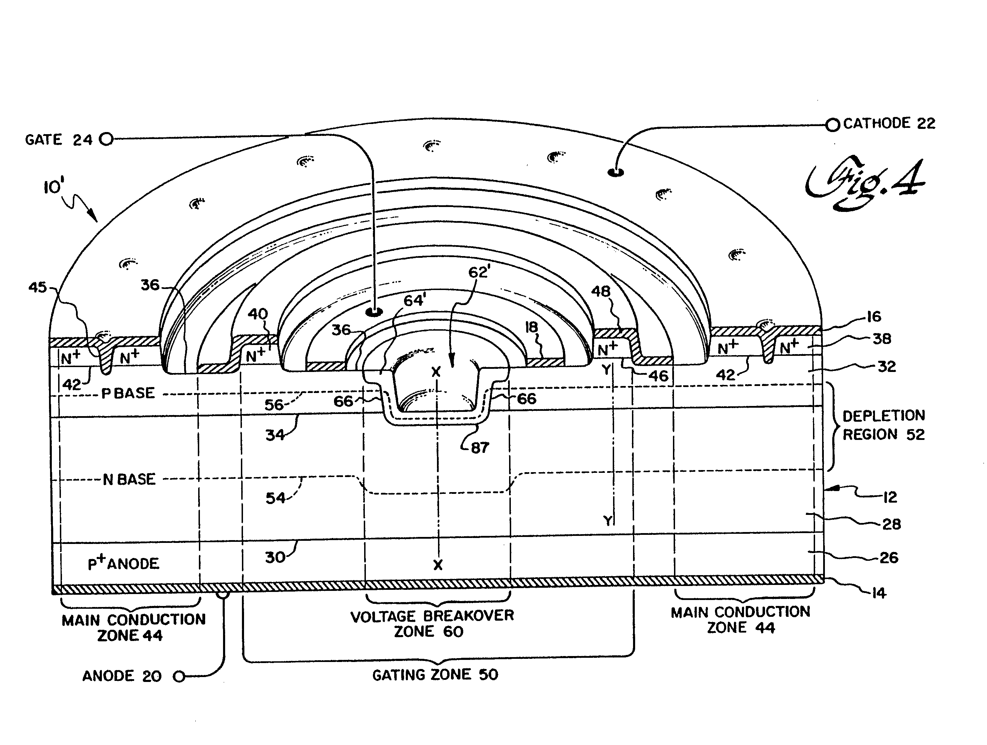

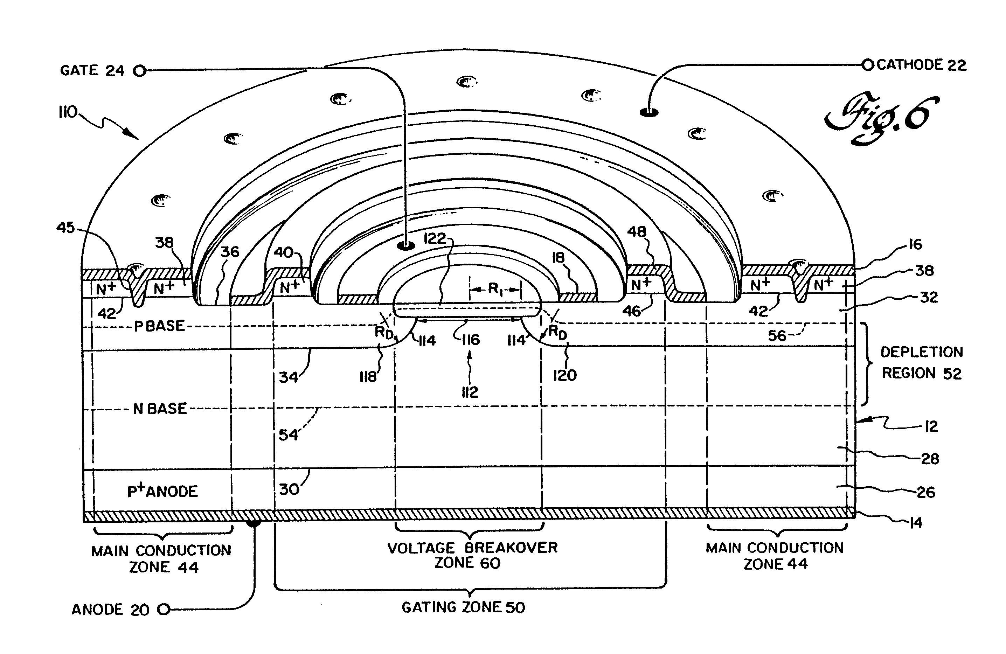

Referring finally to Figure 6, depicted is the manner in which a field-containing layer can be applied to a self-protected device of the type including a curved junction for providing a lower breakdown voltage in the voltage breakover zone. This general type of device is disclosed in the above-incorporated Temple Pat. No. 4,079,403, and a detailed analysis of the effect of junction curvature is provided in the literature reference: V. A. K. Temple and M. S. Adler, "Calculation of the Diffusion Curvature Related Avalanche Breakdown in High-Voltage Planar P—N junctions", *IEEE Trans. Electron Devices*, vol. ED-22, No. 10, pp. 910—966, October 1975.

For convenience, identical reference numerals are employed in Figure 6 to designate device elements corresponding to elements of the devices 10 and 10' of Figures 1 and 4, and the descriptions of these in general are not repeated. A significant overall difference in the device 110 of Figure 6 compared to the devices 10 and 10' of Figures 1 and 4 is that the Figure 6 device 110 is planar; there is no recess.

In Figure 6, the localized voltage breakover zone 60 comprises a portion 112 of the first base (N-base) region layer 28 extending through the second base (P-base) region layer 32 such that a portion 114 of the second PN junction 34 has a radius of curvature $R_D$. The subscript "D" refers to the depth of the diffusion, inasmuch as the second base (P-base) layer 32 is formed during manufacture employing planar diffusion processes. As is well known, when a PN junction is formed by diffusion into a bulk semiconductor through a window in an insulating layer, the impurities diffuse downward and also sideways. Hence the junction consists of a plane (or flat) region with approximately cylindrical edges. Thus, the approximately cylindrical edges can be characterized by the radius $R_D$, which, by geometry, is approximately equal to the diffusion depth. These cylindrical edges have profound effects on the junction, especially for the avalanche multiplication process, as particularly discussed in the above-identified Temple and Adler literature reference.

In addition, a gap 116 of distance 2R, is defined by the extending portion 112 between opposed portions 118 and 120 of the second base (P-base) layer 32. In the annular device configuration illustrated, the gap 116 corresponds to any line across the diameter of the extending portion 112. It will be appreciated that, during device manufacture, a suitable mask, such as an oxide mask, covers the surface of the N-base region 28 in the center where the portion 112 is to extend, and the P-base 32 is then formed in other areas employing gas source diffusion.

As disclosed in the above-incorporated Temple Pat. No. 4,079,403, there are at least two parameters which can be adjusted to control the forward breakover voltage $V_{BF}$. The first of these is the radius of curvature $R_D$. The forward breakover voltage $V_{BF}$ is a direct function of radius of curvature $R_D$. Thus, for a smaller radius of curvature (corresponding to an increased or sharper curvature), achieved by a shallower diffusion for the P-base layer 32, $V_{BF}$ is decreased. Shown in both the Temple Pat. No. 4,079,403 and the Temple and Adler literature reference referred to above is a normalized plot of planar junction breakdown voltage as a function of normalized radius of curvature $R_D$. The radius of curvature $R_D$ is normalized by dividing radius of curvature $R_D$ by ideal case depletion width in the N-base 28 into which the junction curvature 114 projects.

The second parameter which may be adjusted is the distance or diameter $2R_1$, across the gap 116 separating the P-base 32 portions 118 and 120. The smaller the $2R_1$ distance compared to the N-base 28

# 0 129 702

depletion width at breakover voltage, the less pronounced are the effects of the junction curvature at 114, and the higher is the forward breakover voltage $V_{BF}$. As the separation $2R_1$ gets larger, $V_{BF}$ decreases to a limit determined by the junction curvature at 114.

It will be appreciated that an important objective is to provide a thyristor device with the highest possible forward breakover voltage, while at the same time ensuring that initial forward voltage breakover occurs in the localized voltage breakover zone 60. Thus, it is important to be able to adjust $V_{BF}$ during manufacture. While control of the parameters $R_D$ and $2R_1$ does enable such adjustment, the adjustment is limited to achieving a maximum $V_{BF}$ in the order of only 90% of the ideal $V_{BF}$. If this percentage figure could be increased, then the overall device can have a higher $V_{BF}$ rating.

As thus far described, the device 110 corresponds to the device structures disclosed in the above-incorporated Temple Pat. No. 4,079,403. A significant difference, however, is the inclusion in the Figure 6 device 110 of the present invention of a field-containing layer 122 in the surface-adjacent region of the extending portion 112. The field-containing layer 122 is of P conductivity type, but doped higher in concentration than the second base (P-base) region layer 32. The field-containing layer 122 thus forms an electrical extension of the second base (P-base) region layer 32.

As in the embodiments described hereinabove, the field-containing layer serves to reduce the electric field to zero at the device semiconductor surface. The significant advantage diminishing the possibility of device failure due to surface current during breakover and eliminating the need for surface passivation are achieved. Accordingly, the thickness of the field-containing layer 122 exceeds the depletion layer width in the field-containing layer 122 under device forward blocking conditions when the second PN junction 34 is reverse biased.

Another advantage of the field-containing layer 122 in Figure 6 is greater control over the forward breakover voltage $V_{BF}$ in the voltage breakover zone. In particular, $V_{BF}$ is increased to a level even higher than 90% of the ideal $V_{BF}$.

As in the cases of the devices 10 and 10' of Figures 1 and 4, the Figure 6 device 110 may also be gated by light. Similarly, the device need not be an amplifying-gate thyristor.

While specific embodiments of the invention have been illustrated and described herein, it is realized that numerous modifications and changes within the scope of the claims will occur to those skilled in the art. For example, the invention applies to complementary devices, wherein P-type regions are used in place of the N-type regions described herein, and vice-versa. It is therefore to be understood that the appended claims are intended to cover all such modifications and changes as fall within the scope of the invention.

## Claims

1. A thyristor semiconductor switching device self-protected against voltage breakover failure, said device comprising:

a first main terminal region (26) of one conductivity type;

a first base region layer (28) of opposite conductivity type overlying said first main terminal region and defining a first PN junction (30) with said first main terminal region;

a second base region layer (32) of the one conductivity type overlying said first base region layer and defining a second PN junction (34) with said first base region layer, said second base region layer having a boundary (36) opposite said second PN junction;

a second main terminal region (38) of the opposite conductivity type overlying a portion of said second base region layer and defining a third PN junction (42) with said second base region layer at a portion of the second base region boundary, said third PN junction generally defining the location of a main conduction zone (44) within said device; and

a localized avalanche voltage breakover zone (60) in a portion of said device separate from said main conduction zone, said avalanche voltage breakover zone including a recess (62) extending from said second base region boundary (36) into said device, to a depth sufficient to reduce the breakdown voltage of said second PN junction in said avalanche voltage breakover zone, the surface-adjacent region of said recess comprising a field-containing layer (64) of the one conductivity type doped higher in concentration than said second base region layer (32) and forming an electrical extension of said second base region layer, the thickness of the field-containing layer being greater than the depletion-layer width in said field-containing layer under device forward blocking conditons when said second PN junction is reverse-biased.

2. The semiconductor device in accordance with Claim 1, wherein said recess extends from said second base region boundary only partly through said second base region layer.

3. The semiconductor device in accordance with Claim 1, wherein said recess extends from said second base region boundary completely through said second base region layer.

4. The semiconductor device in accordance with Claim 1, wherein said field-containing layer comprises an ion-implanted region.

5. The semiconductor device in accordance with Claim 2, wherein said field-containing layer comprises an ion-implanted region.

6. The semiconductor device in accordance with Claim 3, wherein said field-containing, layer comprises an ion-implanted region.

10

7. The semiconductor device in accordance with Claim 1, further comprising a gating zone (50) located separate from said main conduction zone, said avalanche voltage breakover zone being situated inwardly of said gating zone.

8. The semiconductor device in accordance with Claim 7, wherein said gating zone (50) is actuable by light to trigger said device into conduction.

9. The semiconductor device in accordance with Claim 7, wherein said gating zone includes a generally ring-like gate electrode (18) in electrical contact with said second base region layer, said recess of said avalanche voltage breakover zone being located inwardly of the generally ring-like configuration of said gate electrode.

10. The semiconductor device in accordance with Claim 7, which further comprises a generally ring-like pilot emitter (40) of the opposite conductivity type surrounding said gating zone and defining a fourth PN junction (46) with said second base region boundary, and an ohmic contact (48) between said pilot emitter and a portion of said second base region layer immediately outside the ring-like configuration of said pilot emitter.

11. The semiconductor device in accordance with Claim 8, further comprising a generally ring-like pilot emitter (40) of the opposite conductivity type surrounding said gating zone and defining a fourth PN junction (46) with said second base region boundary, and an ohmic contact (48) between said pilot emitter and a portion of said second base region layer immediately outside the ring-like configuration of said pilot emitter.

12. The semiconductor device in accordance with Claim 9, further comprising a generally ring-like pilot emitter (40) of the opposite conductivity type surrounding said gate electrode (18) of said gating zone and defining a fourth PN junction (46) with said second base region boundary, and an ohmic contact (48) between said pilot emitter and a portion of said second base region layer immediately outside the ring-like configuration of said pilot emitter.

13. An amplified gate thyristor semiconductor switching device self-protected against voltage breakover failure, said device comprising:

a first main terminal region (26) of one conductivity type;

a first base region layer (28) of opposite conductivity type overlying said first main terminal region and defining a first PN junction (30) with said first main terminal region;

a second base region layer (32) of the one conductivity type overlying said first base region layer and defining a second PN junction (34) with said first base region layer, said second base region layer having a boundary (36) opposite said second PN junction;

a second main terminal region (38) of the opposite conductivity type overlying a portion of said second base region layer and defining a third PN junction (42) with said second base region layer at a portion of the second base region boundary, said third PN junction generally defining the location of a main conduction zone (44) within said device;

a gating zone (50) located separately from said main conduction zone;

a generally ring-like pilot emitter (40) of the opposite conductivity type surrounding said gating zone and defining a fourth PN junction (46) with said second base region boundary, and an ohmic contact (48) between said pilot emitter and a portion of said second base region layer immediately outside the ring-like configuration of said pilot emitter; and

a localized avalanche voltage breakover zone (60) situated inwardly of said gating zone, said avalanche voltage breakover zone including a recess (62) extending from said second base region boundary into said device, to a depth sufficient to reduce the breakdown voltage of said second PN junction in said avalanche voltage breakover zone, the surface-adjacent of said recess comprising a field-containing layer (64) of the one conductivity type and doped higher in concentration than said second base region layer and forming an electrical extension of said second base region layer, the thickness of said field-containing layer being greater than the depletion-layer width in said field-containing layer under device forward blocking conditions when said second PN junction is reverse-biased.

14. The semiconductor device in accordance with Claim 13, wherein said recess extends from said second base region boundary only partly through said second base region layer.

15. The semiconductor device in accordance with Claim 13, wherein said recess extends from said second base region boundary completely through said second base region layer.

16. The semiconductor device in accordance with Claim 13, wherein said field-containing layer comprises an ion-implanted region.

17. The semiconductor device in accordance with Claim 14, wherein said field-containing layer comprises an ion-implanted region.

18. The semiconductor device in accordance with Claim 15, wherein said field-containing layer comprises an ion-implanted region.

19. The semiconductor device in accordance with Claim 13, wherein said gating zone is actuable by light to trigger said device into conduction.

20. The semiconductor device in accordance with Claim 13, wherein said gating zone includes a generally ring-like gate electrode (18) in electrical contact with said second base region layer, said recess of said avalanche voltage breakover zone being located inwardly the generally ring-like configuration of said gate electrode.

21. A thyristor semiconductor switching device self-protected against voltage breakover failure, said device comprising:

a first main terminal region (26) of one conductivity type;

a first base region layer (28) of opposite conductivity type overlying said first main terminal region and defining a first PN junction (30) with said first main terminal region;

a second base region layer (32) of the one conductivity type overlying said first base region layer and defining a second PN junction (34) with said first base region layer, said second base region layer having a boundary opposite said second PN junction;

a second main terminal region (38) of the opposite conductivity type overlying a portion of said second base region layer and defining a third PN junction (42) with said second base region layer at a portion of the second base region boundary, said third PN junction generally defining the location of a main conduction zone (44) within said device; and

a localized avalanche voltage breakover zone (60) in a portion of said device separate from said main conduction zone, said avalanche voltage breakover zone including a portion of said first base region layer (28) extending through said second base region layer (32) such that a portion of said second PN junction has a radius of curvature and such that a gap (116) is defined by said extending portion between opposed portions of said second base region layer, the surface-adjacent region of said extending portion comprising a field-containing layer (122) of the one conductivity type doped higher in concentration than said second base region and forming an electrical extension of said second base region layer, the thickness of the field-containing layers being greater than the depletion-layer width in said field-containing layer being greater than the depletion-layer width in said field-containing layer under device forward blocking conditions when said second PN junction is reverse-biased.

22. The semiconductor device in accordance with Claim 21, wherein said field-containing layer comprises an ion-implanted region.

23. The semiconductor device in accordance with Claim 21, further comprising a gating zone (50) located separate from said main conduction zone (44), said avalanche voltage breakover zone (60) being situated inwardly of said gating zone.

24. The semiconductor device in accordance with Claim 23, wherein said gating zone is actuable by light to trigger said device into conduction.

25. The semiconductor device in accordance with Claim 23, wherein said gating zone includes a generally ring-like gate electrode (18) in electrical contact with said second base region layer (32), said avalanche voltage breakover zone being located inwardly of the generally ring-like configuration of said gate electrode.

26. The semiconductor device in accordance with Claim 23, which further comprises a generally ring-like pilot emitter (40) of the opposite conductivity type surrounding said gating zone (50) and defining a fourth PN junction (46) with said second base region boundary, and an ohmic contact (48) between said pilot emitter and a portion of said second base region layer immediately outside the ring-like configuration of said pilot emitter.

27. The semiconductor device in accordance with Claim 24, further comprising a generally ring-like pilot emitter (40) of the opposite conductivity type surrounding said gating zone (50) and defining a fourth PN junction (46) with said second base region boundary, and an ohmic contact between said pilot emitter (48) and a portion of said second base region layer immediately outside the ring-like configuration of said pilot emitter.

28. The semiconductor device in accordance with Claim 25, further comprising a generally ring-like pilot emitter (40) of the opposite conductivity type surrounding said gate electrode of said gating zone and defining a fourth PN junction (46) with said second base region boundary, and an ohmic contact (48) between said pilot emitter and a portion of said second base region layer immediately outside the ring-like configuration of said pilot emitter.

**Patentansprüche**

1. Thyristorhalbleiterschaltvorrichtung mit Selbstschutz vor Fehlzündung, wobei die Vorrichtung aufweist:

ein erstes Hauptanschlußgebiet (26) eines Leitungstyps;

eine erste Basisgebietsschicht (28) entgegengesetzten Leitungstyps, die dem ersten Hauptanschlußgebiet überlagert ist und mit dem ersten Hauptanschlußgebiet einen ersten PN-Übergang (30) bildet;

eine zweite Basisgebietsschicht (32) des einen Leitungstyps, die der ersten Basisgebietsschicht überlagert ist und mit der ersten Basisgebietsschicht einen zweiten PN-Übergang (34) bildet, wobei die zweite Basisgebietsschicht eine Grenze (36) entgegengesetzt zu dem zweiten PN-Übergang hat;

ein zweites Hauptanschlußgebiet (38) des entgegengesetzten Leitungstyps, das einem Teil der zweiten Basisgebietsschicht überlagert ist und einen dritten PN-Übergang (42) mit der zweiten Basisgebietsschicht in einem Teil der zweiten Basisgebietsgrenze bildet, wobei der dritte PN-Übergang insgesamt die Lage einer Hauptleitungszone (44) innerhalb der Vorrichtung festlegt; und

eine lokal begrenzte Lawinendurchbruchspannungskippzone (60) in einem Teil der Vorrichtung getrennt von der Hauptleitungszone, wobei die Lawinendurchbruchspannungskippzone eine Ausnehmung (62) aufweist, die sich von der zweiten Baisgebietsgrenze (36) in die Vorrichtung bis in eine Tiefe erstreckt, die ausreicht, um die Durchbruchspannung des zweiten PN-Übergangs in der Lawinendurchbruchspannungskippzone zu reduzieren, wobei das der Oberfläche benachbarte Gebiet der Ausnehmung eine ein Feld enthaltende Schicht (64) des einen Leitungstyps aufweist, die in der Konzentration höher dotiert ist als die zweite Basisgebietsschicht (32) und einen elektrischen Fortsatz der zweiten Basisgebietsschicht bildet, wobei die Dicke der ein Feld enthaltenden Schicht größer ist als die Verarmungsschichtbreite in der ein Feld enthaltenden Schicht unter Vorwärts-Sperrzuständen der Vorrichtung, wenn der zweite PN-Übergang in Sperrrichtung vorgespannt ist.

2. Halbleitervorrichtung nach Anspruch 1, wobei sich die Ausnehmung von der zweiten Basisgebietsgrenze aus nur teilweise durch die zweite Basisgebietsschicht erstreckt.

3. Halbleitervorrichtung nach Anspruch 1, wobei sich die Ausnehmung von der zweiten Basisgebietsgrenze aus vollständig durch die zweite Basisgebietsschicht erstreckt.

4. Halbleitervorrichtung nach Anspruch 1, wobei die ein Feld enthaltende Schicht ein ionenimplantiertes Gebiet aufweist.

5. Halbleitervorrichtung nach Anspruch 2, wobei die ein Feld enthaltende Schicht ein ionenimplantiertes Gebiet aufweist.

6. Halbleitervorrichtung nach Anspruch 3, wobei die ein Feld enthaltende Schicht ein ionenimplantiertes Gebiet aufweist.

7. Halbleitervorrichtung nach Anspruch 1, die weiter eine Ansteuerzone (50) aufweist, welche separat von der Hauptleitungszone angeordnet ist, wobei sich die Lawinendurchbruchspannungskippzone einwärts der Ansteuerzone befindet.

8. Halbleitervorrichtung nach Anspruch 7, wobei die Ansteuerzone (50) durch Licht betätigbar ist, um die Vorrichtung in den leitenden Zustand zu triggern.

9. Halbleitervorrichtung nach Anspruch 7, wobei die Ansteuerzone eine insgesamt ringartige Steuerelektrode (18) in elektrischem Kontakt mit der zweiten Basisgebietsschicht aufweist, wobei die Ausnehmung der Lawinendurchbruchspannungskippzone einwärts der insgesamt ringartigen Konfiguration der Steuerelektrode angeordnet ist.

10. Halbleitervorrichtung nach Anspruch 7, welche weiter einen ringartigen Hilfsemitter (40) des entgegengesetzten Leitungstyps aufweist, der die Ansteuerzone umgibt und einen vierten PN-Übergang (46) mit der zweiten Basisgebietsgrenze bildet, und einen ohmschen Kontakt (48) zwischen dem Hilfsemitter und einem Teil der zweiten Basisgebietsschicht unmittelbar außerhalb der ringartigen Konfiguration des Hilfsemitters.

11. Halbleitervorrichtung nach Anspruch 8, mit einem insgesamt ringartigen Hilfsemitter (40) des entgegengesetzten Leitungstyps, der die Ansteuerzone umgibt und einen vierten PN-Übergang (46) mit der zweiten Basisgebietsgrenze bildet, und mit einem ohmschen Kontakt (48) zwischen dem Hilfsemitter und einem Teil der zweiten Basisgebietsschicht unmittelbar außerhalb der ringartigen Konfiguration des Hilfsemitters.

12. Halbleitervorrichtung nach Anspruch 9, die weiter einen insgesamt ringartigen Hilfsemitter (40) des entgegengesetzten Leitungstyps aufweist, der die Steuerelektrode (18) der Ansteuerzone umgibt und einen vierten PN-Übergang (46) mit der zweiten Basisgebietsgrenze bildet, und einen ohmschen Kontakt (48) zwischen dem Hilfsemitter und einem Teil der zweiten Basisgebietsschicht unmittelbar außerhalb der ringartigen Konfiguration des Hilfsemitters.

13. Thyristorhalbleiterschaltvorrichtung mit innerer Zündverstärkung und mit Selbstschutz vor Fehlzündung, wobei die Vorrichtung aufweist:

ein erstes Hauptanschlußgebiet (26) eines Leitungstyps;

eine erste Basisgebietsschicht (28) entgegengesetzten Leitungstyps, die dem ersten Hauptanschlußgebiet überlagert ist und einen ersten PN-Übergang (30) mit dem ersten Hauptanschlußgebiet bildet;

eine zweite Basisgebietsschicht (32) des einen Leitungstyps, die der ersten Basisgebietsschicht überlagert ist und einen zweiten PN-Übergang (34) mit der ersten Basisgebietsschicht bildet, wobei die zweite Basisgebietsschicht eine Grenze (36) entgegengesetzt zu dem zweiten PN-Übergang hat;

ein zweites Hauptanschlußgebiet (38) des entgegengesetzten Leitungstyps, das einem Teil der zweiten Basisgebietsschicht überlagert ist und einen dritten PN-Übergang (42) mit der zweiten Basisgebietsschicht in einem Teil der zweiten Basisgebietsgrenze bildet, wobei der dritte PN-Übergang insgesamt die Lage einer Hauptleitungszone (44) innerhalb der Vorrichtung festlegt;

eine Ansteuerzone (50), die separat von der Hauptleitungszone angeordnet ist;

einen insgesamt ringartigen Hilfsemitter (40) des entgegengesetzten Leitungstyps, der die Ansteuerzone umgibt und einen vierten PN-Übergang (46) mit der zweiten Basisgebietsgrenze bildet, und einen ohmschen Kontakt (48) zwischen dem Hilfsemitter und einem Teil der zweiten Basisgebietsschicht unmittelbar außerhalb der ringartigen Konfiguration des Hilfsemitters; und

eine örtlich begrenzte Lawinendurchbruchspannungskippzone (60), die einwärts der Ansteuerzone angeordnet ist, wobei die Lawinendurchbruchspannungskippzone eine Ausnehmung (62) aufweist, die sich von der zweiten Basisgebietsgrenze aus in die Vorrichtung bis in eine Tiefe erstreckt, welche ausreicht, um die Durchbruchspannung des zweiten PN-Übergangs in der Lawinendurchbruchspannungskippzone zu reduzieren, wobei das der Oberfläche benachbarte Gebiet der Ausnehmung eine ein Feld enthaltende

**0 129 702**

Schicht (64) des einen Leitungstyps aufweist, die in der Konzentration höher als die zweite Basisgebietsschicht dotiert ist und einen elektrischen Fortsatz der zweiten Basisgebietsschicht bildet, wobei die Dicke der in Feld enthaltenden Schicht größer ist als die Verarmungsschichtbreite in der ein Feld enthaltenden Schicht unter Vorwärts-Sperrzuständen der Vorrichtung, wenn der zweite PN-Übergang in Sperrrichtung vorgespannt ist.

14. Halbleitervorrichtung nach Anspruch 13, wobei sich die Ausnehmung von der zweiten Basisgebietsgrenze aus nur teilweise durch die zweite Basisgebietsschicht erstreckt.

15. Halbleitervorrichtung nach Anspruch 13, wobei sich die Ausnehmung der zweiten Basisgebietsgrenze aus vollständig durch die zweite Basisgebietsschicht erstreckt.

16. Halbleitervorrichtung nach Anspruch 13, wobei die ein Feld enthaltende Schicht ein ionenimplantiertes Gebiet umfaßt.

17. Halbleitervorrichtung nach Anspruch 14, wobei die ein Feld enthaltende Schicht ein ionenimplantiertes Gebiet umfaßt.

18. Halbleitervorrichtung nach Anspruch 15, wobei die ein Feld enthaltende Schicht ein ionenimplantiertes Gebiet umfaßt.

19. Halbleitervorrichtung nach Anspruch 13, wobei die Ansteuerzone durch Licht betätigbar ist, um die Vorrichtung in den leitenden Zustand zu triggern.

20. Halbleitervorrichtung nach Anspruch 13, wobei die Ansteuerzone eine insgesamt ringartige Steuerelektrode (18) in elektrischem Kontakt mit der zweiten Basisgebietsschicht aufweist, wobei die Ausnehmung der Lawinendurchbruchspannungskippzone einwärts der insgesamt ringartigen Konfiguration der Steuerelektrode angeordnet ist.

21. Thyristorhalbleiterschaltvorrichtung mit Selbstschutz gegen Fehlzündung, wobei die Vorrichtung aufweist:

ein erstes Hauptanschlußgebiet (26) eines Leitungstyps;

eine erste Basisgebietsschicht (28) entgegengesetzten Leitungstyps, die dem ersten Hauptanschlußgebiet überlagert ist und einen ersten PN-Übergang (30) mit dem ersten Hauptanschlußgebiet bildet;

eine zweite Basisgebietsschicht (32) des einen Leitungstyps, die der ersten Basisgebietsschicht überlagert ist und einen zweiten PN-Übergang (34) mit der ersten Basisgebietsschicht bildet, wobei die zweite Basisgebietsschicht eine Grenze entgegengesetzt zu dem zweiten PN-Übergang hat;

ein zweites Hauptanschlußgebiet (38) des entgegengesetzten Leitungstyps, das einem Teil der zweiten Basisgebietsschicht überlagert ist und einen dritten PN-Übergang (42) mit der zweiten Basisgebietsschicht in einem Teil der zweiten Basisgebietsgrenze bildet, wobei der dritte PN-Übergang insgesamt die Lage einer Hauptleitungszone (44) innerhalb der Vorrichtung festlegt; und

eine lokal begrenzte Lawinendurchbruchspannungskippzone (60) in einem Teil der Vorrichtung separat von der Hauptleitungszone, wobei die Lawinendurchbruchspannungskippzone einen Teil der ersten Basisgebietsschicht (28) aufweist, die sich durch die zweite Basisgebietsschicht (32) erstreckt, so daß ein Teil des zweiten PN-Übergangs einen derartigen Krümmungsradius hat, daß ein Spalt (116) durch den sich erstreckenden Teil zwischen den entgegengesetzten Teilen des zweiten Basisgebietsschicht gebildet ist, wobei das der Oberfläche benachbarte Gebiet des sich erstreckenden Teils eine ein Feld enthaltende Schicht (122) des einen Leitungstyps aufweist, die in der Konzentration höher dotiert ist als das zweite Basisgebiet und einen elektrischen Fortsatz der zweiten Basisgebietsschicht bildet, wobei die Dicke der ein Feld enthaltenden Schichten größer ist als die Verarmungsschichtbreite in der ein Feld enthaltenden Schicht unter Vorwärts-Sperrzuständen der Vorrichtung, wenn der zweite PN-Übergang in Sperrrichtung vorgespannt ist.

22. Halbleitervorrichtung nach Anspruch 21, dadurch gekennzeichnet, daß die ein Feld enthaltende Schicht ein ionenimplantiertes Gebiet umfaßt.

23. Halbleitervorrichtung nach Anspruch 21, die weiter eine Ansteuerzone (50) aufweist, welche separat von der Hauptleitungszone (44) angeordnet ist, wobei sich die Lawinendurchbruchspannungskippzone (60) einwärts der Ansteuerzone befindet.

24. Halbleitervorrichtung nach Anspruch 23, wobei die Ansteuerzone durch Licht betätigbar ist, um die Vorrichtung in den leitenden Zustand zu triggern.

25. Halbleitervorrichtung nach Anspruch 23, wobei die Ansteuerzone eine insgesamt ringartige Steuerelektrode (18) in elektrischem Kontakt mit der zweiten Basisgebietsschicht (32) aufweist, wobei die Lawinendurchbruchspannungskippzone einwärts der insgesamt ringartigen Konfiguration der Steuerelektrode angeordnet ist.

26. Halbleitervorrichtung nach Anspruch 23, die weiter einen insgesamt ringartigen Hilfsemitter (40) des entgegengesetzten Leitungstyps aufweist, der die Ansteuerzone (50) umgibt und einen vierten PN-Übergang (46) mit der zweiten Basisgebietsgrenze bildet, und einen ohmschen Kontakt (48) zwischen dem Hilfsemitter und einem Teil der zweiten Basisgebietsschicht unmittelbar außerhalb der ringartigen Konfiguration des Hilfsemitters.

27. Halbleitervorrichtung nach Anspruch 24, die weiter einen insgesamt ringartigen Hilfsemitter (40) des entgegengesetzten Leitungstyps aufweist, der die Ansteuerzone (50) umgibt und einen vierten PN-Übergang (46) mit der zweiten Basisgebietsgrenze bildet, und einen ohmschen Kontakt zwischen dem Hilfsemitter (48) und einem Teil der zweiten Basisgebietsschicht unmittelbar außerhalb der ringartigen Konfiguration des Hilfsemitters.

14

28. Halbleitervorrichtung nach Anspruch 25, die weiter einen insgesamt ringartigen Hilfsemitter (40) des entgegengesetzten Leitungstyps aufweist, der die Steuerelektrode der Ansteuerzone umgibt und einen vierten PN-Übergang (46) mit der zweiten Basisgebietsgrenze bildet, und einen ohmschen Kontakt (48) zwischen dem Hilfsemitter und einem Teil der zweiten Basisgebietsschicht unmittelbar außerhalb der ringartigen Konfiguration des Hilfsemitters.

**Revendications**

1. Dispositif de commutation en semi-conducteur formant un thyristor, auto-protégé contre une défaillance de recouvrement de la tension, le dispositif comprenant:

une première région terminale principale (26) d'un premier type de conductivité;

une première couche (28) de région de base de type de conductivité opposé recouvrant la première région terminale principale et définissant une première jonction PN (30) avec la première région terminale principale;

une seconde couche (32) de région de base du premier type de conductivité recouvrant la première couche de la région de base et définissant une seconde jonction PN (34) avec la première couche de la région de base, la seconde couche de la région de base ayant une limite (36) opposée à la seconde jonction PN;

une seconde région terminale principale (38) du type de conductivité opposé recouvrant une partie de la seconde couche de la région de base et définissant une troisième jonction PN (42) avec la seconde couche de la région de base à une partie de la limite de la seconde région de base, la troisième jonction PN définissant généralement l'emplacement d'une zone principale de conduction (44) à l'intérieur du dispositif; et

une zone localisée de recouvrement de la tension d'avalanche (60) dans une partie du dispositif séparée de la zone principale de conduction, la zone de recouvrement de la tension d'avalanche comportant un évidement (62) s'étendant à partir de la limite (36) de la seconde région de base jusque dans le dispositif, suivant une profondeur suffisante pour réduire la tension de rupture de la seconde jonction PN dans la zone de recouvrement de la tension d'avalanche, la région contiguë à la surface de l'évidement comprenant une couche renfermant le champ (64) du premier type de conductivité dopée avec une concentration plus élevée que la seconde couche (32) de la région de base et formant une extension électrique de la seconde couche de la région de base, l'épaisseur de la couche renfermant le champ étant supérieure à la largeur de la couche d'épuisement dans la couche renfermant le champ dans des conditions de blocage direct du dispositif lorsque la seconde jonction PN est soumise à une polarisation inverse.

2. Dispositif semi-conducteur selon la revendication 1, dans lequel l'évidement s'étend à partir de la limite de la seconde région de base seulement en partie à travers la seconde couche de la région de base.

3. Dispositif semi-conducteur selon la revendication 1, dans lequel l'évidement s'étend à partir de la limite de la seconde région de base en totalité à travers la seconde couche de la région de base.

4. Dispositif semi-conducteur selon la revendication 1, dans lequel la couche renfermant le champ comprend une région implantée ioniquement.

5. Dispositif semi-conducteur selon la revendication 2, dans lequel la couche renfermant le champ comprend une région implantée ioniquement.

6. Dispositif semi-conducteur selon la revendication 3, dans lequel la couche renfermant le champ comprend une région implantée ioniquement.

7. Dispositif semi-conducteur selon la revendication 1, comprenant en outre une zone de contrôle (50) située en étant séparée de la zone principale de conduction, la zone de recouvrement de la tension d'avalanche se trouvant à l'intérieur de la zone de contrôle.

8. Dispositif semi-conducteur selon la revendication 7, dans lequel la zone de contrôle (50) est mise en oeuvre par de la lumière afin de faire passer le dispositif à l'état de conduction.

9. Dispositif semi-conducteur selon la revendication 7, dans lequel la zone de contrôle comporte une électrode de grille (18) ayant la forme générale d'un anneau en contact électrique avec la seconde couche de la région de base, l'évidement de la zone de recouvrement de la tension d'avalanche étant située à l'intérieur de la configuration ayant la forme générale d'un anneau de l'électrode de grille.

10. Dispositif semi-conducteur selon la revendication 7, qui comprend en outre un émetteur pilote (40) ayant la forme générale d'un anneau du type de conductivité opposé qui entoure la zone de contrôle et définit une quatrième jonction PN (46) avec la limite de la seconde région de base, et un contact ohmique (48) entre l'émetteur pilote et une partie de la seconde couche de la région de base immédiatement à l'extérieur de la configuration en forme d'anneau de l'émetteur pilote.

11. Dispositif semi-conducteur selon la revendication 8, comprenant en outre un émetteur pilote (40) ayant la forme générale d'un anneau du type de conductivité opposé entourant la zone de contrôle et définissant une quatrième jonction PN (46) avec la limite de la seconde région de base, et un contact ohmique (48) entre l'émetteur pilote et une partie de la seconde couche de la région de base immédiatement à l'extérieur de la configuration en forme d'anneau de l'émetteur pilote.

12. Dispositif semi-conducteur selon la revendication 9, comprenant en outre un émetteur pilote (40) ayant la forme générale d'un anneau du type de conductivité opposé entourant l'électrode de grille (18) de la zone de contrôle et définissant une quatrième jonction PN (46) avec la limite de la seconde région de

# 0 129 702

base, et une contact ohmique (48) entre l'émetteur pilote et une partie de la seconde couche de la région de base immédiatement à l'extérieur de la configuration en forme d'anneau de l'émetteur pilote.

13. Dispositif de commutation en semi-conducteur formant thyristor à grille amplifiée, auto-protégé contre une défaillance de recouvrement de la tension, le dispositif comprenant:

—une première région terminale principale (26) d'un premier type de conductivité;

—une première couche (28) de région de base du type de conductivité opposé recouvrant la première région terminale principale et définissant une première jonction PN (30) avec la première région terminale principale;

—une seconde couche (32) de région de base du premier type de conductivité recouvrant la première couche de la région de base et définissant une seconde jonction PN (34) avec la première couche de la région de base, la seconde couche de la région de base ayant une limite (36) opposée à la seconde jonction PN;

—une seconde région terminale principale (38) du type de conductivité opposé recouvrant une partie de la seconde couche de la région de base et définissant une troisième jonction PN (42) avec la seconde couche de la région de base à une partie de la limite de la seconde région de base, la troisième jonction PN définissant généralement l'emplacement d'une zone principale de conduction (44) à l'intérieur du dispositif;

—une zone de contrôle (50) située en étant séparée de la zone principale de conduction;

—un émetteur pilote (40) ayant la forme générale d'un anneau du type de conductivité opposé entourant la zone de contrôle et définissant une quatrième jonction PN (46) avec la limite de la seconde région de base, et un contact ohmique (48) entre l'émetteur pilote et une partie de la seconde couche de la région de base immédiatement à l'extérieur de la configuration en forme d'anneau de l'émetteur pilote;

—une zone localisée (60) de recouvrement de la tension d'avalanche située à l'intérieur de la zone de contrôle, la zone de recouvrement de la tension d'avalanche comportant un évidemment (62) s'étendant entre la limite de la seconde région de base jusque dans le dispositif, suivant une profondeur suffisante pour réduire la tension de rupture de la seconde jonction PN dans la zone de recouvrement de la tension d'avalanche, la surface contiguë de l'évidement comprenant une couche (64) renfermant le champ du premier type de conductivité et dopée avec une concentration plus élevée que la seconde couche de la région de base et formant une extension électrique de la seconde couche de la région de base, l'épaisseur de la couche renfermant le champ étant supérieure à la largeur de la couche d'épuisement dans la couche renfermant le champ dans des conditions de blocage direct du dispositif lorsque la seconde jonction PN est soumise à une polarisation inverse.

14. Dispositif semi-conducteur selon la revendication 13, dans lequel l'évidement s'étend à partir de la limite de la seconde région de base seulement en partie à travers la seconde couche de la région de base.

15. Dispositif semi-conducteur selon la revendication 13, dans lequel l'évidement s'étend à partir de la limite de la seconde région de base en totalité à travers la seconde couche de la région de base.

16. Dispositif semi-conducteur selon la revendication 13, dans lequel la couche renfermant le champ comprend une région implantée ioniquement.

17. Dispositif semi-conducteur selon la revendication 14, dans lequel la couche renfermant le champ comprend une région implantée ioniquement.

18. Dispositif semi-conducteur selon la revendication 15, dans lequel la couche renfermant le champ comprend une région implantée ioniquement.

19. Dispositif semi-conducteur selon la revendication 13, dans lequel la zone de contrôle est mise en oeuvre par de la lumière afin de faire passer le dispositif à l'état de conduction.

20. Dispositif semi-conducteur selon la revendication 13, dans lequel la zone de contrôle comporte une électrode de grille (18) ayant la forme générale d'un anneau en contact électrique avec la seconde couche de la région de base, l'évidement de la zone de recouvrement de la tension d'avalanche étant situé à l'intérieur de la configuration ayant la forme générale d'un anneau de l'électrode de grille.

21. Dispositif de commutation en semi-conducteur formant thyristor, auto-protégé contre une défaillance de recouvrant de la tension, le dispositif comprenant:

—une première région terminale principale (26) d'un premier type de conductivité;

—une première couche (28) de région de base du type de conductivité opposé recouvant la première région terminale principale et définissant une première jonction PN (30) avec la première région terminale principale;

—une seconde couche de la région de base (32) du premier type de conductivité recouvrant la première couche de la région de base et définissant une seconde jonction PN (34) avec la première couche de la région de base, la seconde couche de région de base ayant une limite opposée à la seconde jonction PN.

—une seconde région terminale principale (38) du type de conductivité opposé recouvrant une partie de la seconde couche de la région de base et définissant une troisième jonction PN (42) avec la seconde couche de la région de base à une partie de la limite de la seconde région de base, la troisième jonction PN définissant généralement l'emplacement d'une zone principale de conduction (44) à l'intérieur du dispositif; et

une zone localisée (60) de recouvrement de la tension d'avalanche dans une partie du dispositif séparée de la zone principale de conduction la zone de recouvrement de la tension d'avalanche comportant

16

une partie de la première couche (28) de la région de base s'étendant à travers la seconde couche de la région de base (32) de façon qu'une partie de la seconde jonction PN ait un rayon de courbure et qu'un interstice (116) soit défini par cette partie d'extension entre des portions opposées de la seconde couche de la région de base, la région contiguë à la surface de la partie s'étendant comprenant une couche renfermant le champ (122) du premier type de conductivité dopée avec une concentration plus élevée que la seconde région de base et formant une extension électrique de la seconde couche de la région de base, l'épaisseur des couches renfermant le champ étant supérieure à la largeur de la couche d'épuisement dans la couche renfermant le champ dans des conditions de blocage direct du dispositif lorsque la seconde jonction PN est soumise à une polarisation inverse.

22. Dispositif semi-conducteur selon la revendication 21, dans lequel la couche renfermant le champ comprend une région implantée ioniquement.

23. Dispositif semi-conducteur selon la revendication 21, comprenant en outre une zone de contrôle (50) située en étant séparée de la zone principale de conduction (44), la zone (60) de recouvrement de la tension d'avalanche étant située à l'intérieur de la zone de contrôle.

24. Dispositif semi-conducteur selon la revendication 23, dans lequel la zone de contrôle est mise en oeuvre par de la lumière afin de faire passer le dispositif à l'état de conduction.

25. Dispositif semi-conducteur selon la revendication 23, dans lequel la zone de contrôle comprend une électrode de grille (18) ayant la forme générale d'un anneau en contact électrique avec la seconde couche (32) de la région de base, la zone de recouvrement de la tension d'avalanche étant située à l'intérieur de la configuration ayant la forme générale d'un anneau de l'électrode de grille.

26. Dispositif semi-conducteur selon la revendication 23, qui comprend en outre un émetteur pilote (40) ayant la forme générale d'un anneau du type de conductivité opposé entourant la zone de contrôle (50) et définissant une quatrième jonction PN (46) avec la limite de la seconde région de base, et un contact ohmique (48) entre l'émetteur pilote et une partie de la seconde couche de la région de base immédiatement à l'extérieur de la configuration en forme d'anneau de l'émetteur pilote.

27. Dispositif semi-conducteur selon la revendication 24, comprenant en outre un émetteur pilote (40) ayant la forme générale d'un anneau du type de conductivité opposé entourant la zone de contrôle (50) et définissant une quatrième jonction PN (46) avec la limite de la seconde région de base, et un contact ohmique entre l'émetteur pilote (40) et une partie de la seconde couche de la région de base immédiatement à l'extérieur de la configuration en forme d'anneau de l'émetteur pilote.

28. Dispositif semi-conducteur selon la revendication 25, comprenant en outre un émetteur pilote (40) ayant la forme générale d'un anneau du type de conductivité opposé entourant l'électrode de grille de la zone de contrôle et définissant une quatrième jonction PN (46) avec la limite de la seconde région de base, et un contact ohmique (48) entre l'émetteur pilote et une partie de la seconde couche de la région de base immédiatement à l'extérieur de la configuration en forme d'anneau de l'émetteur pilote.

GATE 24 O— ——O CATHODE 22

*Fig.1*

10

45— 36 38 40 62 64 36 18 48 16 38 32

N+ N+ N+ X Y N+ 46 N+ N+

42 46 66 56

P BASE

DEPLETION REGION 52

34 12

N BASE

54 Y 28

30 X 26

P+ ANODE 14

MAIN CONDUCTION ZONE 44 | VOLTAGE BREAKOVER ZONE 60 | MAIN CONDUCTION ZONE 44

ANODE 20 O

GATING ZONE 50

0 129 702

Fig. 2

E PEAK, X-X

E FIELD ALONG X-X

DISTANCE ALONG X-X

Fig. 3

E PEAK, Y-Y

E FIELD ALONG Y-Y

DISTANCE ALONG Y-Y

Fig. 5

E PEAK, X-X

E FIELD ALONG X-X

DISTANCE ALONG X-X

2

GATE 24

CATHODE 22

*Fig. 4*

10'

45

36

40

62'

64'

48

36

18

16

38

32

42

P BASE

56

66

66

42

34

87

DEPLETION
REGION 52

54

N BASE

Y

12

28

P⁺ ANODE

30

26

14

MAIN CONDUCTION
ZONE 44

VOLTAGE BREAKOVER
ZONE 60

MAIN CONDUCTION
ZONE 44

ANODE 20

GATING ZONE 50

N⁺

0 129 702

GATE 24 ◯

◯ CATHODE 22

*Fig. 6*

110

45

38  36  40  122  18  48  16  38  32

N⁺  N⁺  N⁺  R₁  N⁺  N⁺  N⁺

42  46  42

P BASE  R_D  114  116  114  R_D  56

118  120  DEPLETION REGION 52

34  112

N BASE  12

54  28

P⁺ ANODE  30  26

14

MAIN CONDUCTION ZONE 44

VOLTAGE BREAKOVER ZONE 60

MAIN CONDUCTION ZONE 44

ANODE 20 ◯

GATING ZONE 50

0 129 702